# EUROPEAN PATENT APPLICATION

(11) **EP 1 826 576 A2**
(43) Date of publication of application: **29.08.2007**
(21) Application number: 07250745.2
(22) Date of filing: 22.02.2007
(51) Int. Cl.: G01R 13/34, G01R 13/32, G01R 13/02

(54) **Trigger architecture, measurement system and method of use**

(30) Priority: 28.02.2006 US 363939
(71) Applicant: Agilent Technologies, Inc., Santa Clara, California 95051 (US)
(72) Inventor: Corredoura, Paul L., Redwood City, CA 94062 (US)
(74) Representative: Pingree, Oliver Norman

(57) **Abstract**

A trigger architecture (105) includes a plurality of parallel analog-to-digital converters (ADCs) (106,107,108,109,110) operative to garner data samples (116,117,118,119,120) in parallel from an input signal (113) at different times in a clock signal period. The trigger architecture also includes a logic block (111) comprising a plurality of digital comparators (301,302,303,304,305), which are adapted to compare each of the data samples to one or more threshold values in parallel. A measurement system (100) including the trigger architecture (105) is described.

## Description

### Background

Oscilloscopes are ubiquitous in electronic measurement and testing. An oscilloscope can capture a waveform for a period of time (i.e., a 'snapshot') and can then generate an image corresponding to the captured waveform on a display. Additionally, the information captured by the oscilloscope can be stored on a storage device, and further processed to provide a wide range of measurement information:

The waveform data for display are garnered based on preset criteria, often referred to as triggers. When the incoming data stream meets the trigger criterion, a trigger is generated and data from the signal are captured for subsequent display on the oscilloscope. Frequently, the signal being measured with the oscilloscope is a time varying voltage signal. As the need for making measurements on increasingly higher speed signals continues, challenges are presented in the implementation of trigger circuits and architectures of oscilloscopes.

One challenge facing oscilloscope designers is trigger circuit bandwidth. While the overall bandwidth of the oscilloscope has increased, the bandwidth of analog trigger circuits has not achieved the same rate of advancement. Today the bandwidth of analog trigger circuits is insufficient for the bandwidths achieved in today's high signal speed oscilloscopes. For example, known high speed oscilloscopes have used dedicated analog circuitry to generate analog trigger signals. Unfortunately, known analog trigger circuits often do not have sufficient bandwidth to cover the full bandwidth of the scope channel they are generating triggers for.

There is a need, therefore, for a trigger circuit and architecture that preferably overcomes the shortcomings of known trigger circuits and architectures.

### Brief Description of the Drawings

The example embodiments are best understood from the following detailed description when read with the accompanying drawing figures. It is emphasized that the various features are not necessarily drawn to scale. In fact, the dimensions may be arbitrarily increased or decreased for clarity of discussion. Wherever applicable and practical, like reference numerals refer to like elements.

Fig. I A is a simplified block diagram of a measurement system including a trigger architecture in accordance with an example embodiment.

Fig. I B is a simplified block diagram of a trigger architecture in accordance with an example embodiment.

Fig. 2 includes a series of graphs showing the clock signal for each of N analog-to-digital converters (ADC) and the input analog signal sampled by the ADCs in accordance with an example embodiment.

Fig. 3 is a simplified block diagram of a trigger architecture in accordance with an example embodiment.

Fig. 4 is a simplified block diagram of a trigger architecture in accordance with an example embodiment.

Fig. 5A is a simplified block diagram of a trigger architecture in accordance with an example embodiment.

Fig. 5B is a timing diagram showing resampling of an input analog signal in accordance with an example embodiment.

Fig. 6 is a flow-chart of a method of garnering data for display on an oscilloscope in accordance with an example embodiment.

### Detailed Description

In the following detailed description, for purposes of explanation and not limitation, specific details are set forth in order to provide a thorough understanding of example embodiments according to the present teachings. However, it will be apparent to one having ordinary skill in the art having had the benefit of the present disclosure that other embodiments according to the present teachings that depart from the specific details disclosed herein remain within the scope of the appended claims. Moreover, descriptions of well-known apparati and methods may be omitted so as to not obscure the description of the example embodiments. Such methods and apparati are clearly within the scope of the present teachings.

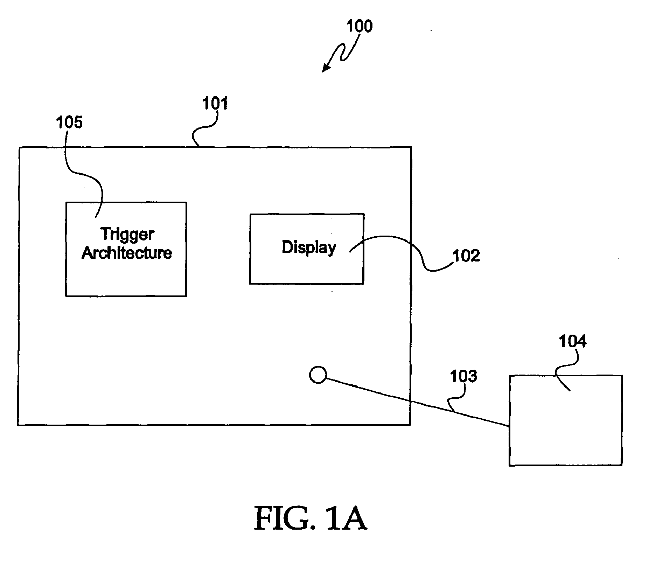

Fig. 1A is a simplified block diagram of a measurement system 100 in accordance with an example embodiment. The measurement system 100 includes an oscilloscope 101. The oscilloscope 101 may be one of a variety of oscilloscopes offered by manufacturers such as Agilent Technologies, Inc., Palo Alto, CA, or Tektronix, Inc., Beaverton, OR. In a specific embodiment, the oscilloscope 101 is one of Agilent's Infinium® Series oscilloscopes. The oscilloscope 101 includes a display 102 and as a probe 103. The probe 103 engages an electronic device under test (DUT) 104, which is often referred to as a target. As many of the noted components of the measurement system 100 are known, details of known components are omitted to avoid obscuring the description of the embodiments.

The oscilloscope 101 also includes a trigger architecture 105 used to generate triggers for data display. As detailed herein, the trigger architecture 105 is implemented in dedicated hardware, or programmable firmware, or both to provide bandwidth capabilities that are substantially the same as the bandwidth of the oscilloscope 101, using components having bandwidths/clock speeds significantly less than those of an input signal and of the oscilloscope 101.

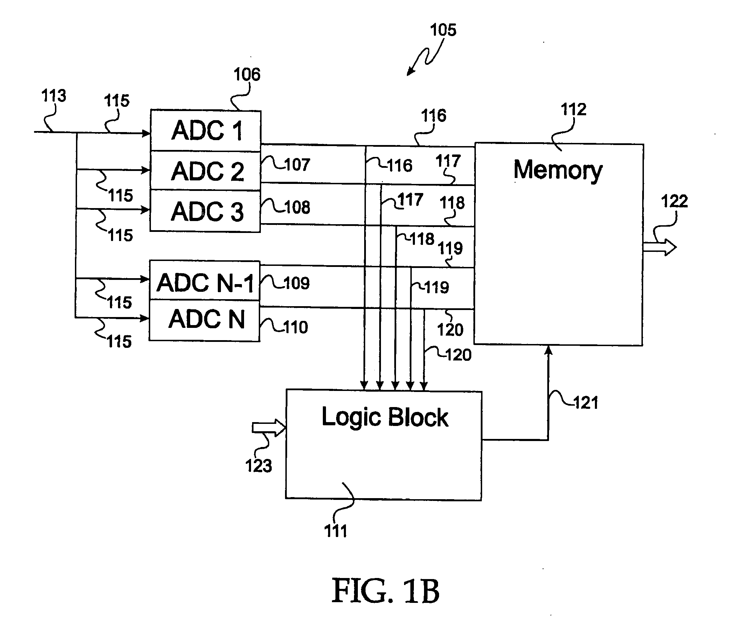

Fig. 1B is a simplified block diagram of the trigger architecture 105 in accordance with an example embodiment. The trigger architecture 105 includes a plurality (N=integer) of ADCs 106-110 adapted to provide digital data samples to a logic block 111. The logic block 111 provides trigger outputs 121 to a memory 112. The memory 112 outputs data to a post processor (not shown) of the oscilloscope 101 via a data bus. After processing, the waveform can be replicated on the display 102.

An input analog signal 113 is garnered from the electronic DUT 104 and is split into a plurality of substantially identical signals 115 using a known splitter (not shown). The signals 115 are provided in parallel to the sequence of ADCs 106-110. In an embodiment, each of the ADCs 106-110 operates on a common clock, which may be a clock of the oscilloscope 101. Regardless of the clock source, the clock signal at each ADC is time-delayed or phase-shifted compared to the clock of the previous ADC. For example, the clock signal of ADC 107 is phase-shifted or time-delayed slightly when compared to the clock signal of ADC 106; and the clock signal of ADC 108 is phase-shifted or time-delayed compared to the clock signal of ADC 107, et cetera.

As the input analog signal 113 is input to each of the ADCs 106-110 in parallel, the ADCs 106-110 each convert an analog data sample into a digital data sample. Because the clocking of each ADC 106-110 is slightly offset compared to the previous and subsequent ADC in the sequence of ADCs of the plurality of ADCs 106-110, the data samples from the input analog signal 113 are also garnered offset in time. Thus, the ADC 106 will garner a data sample from the analog input signal 113 at a point in time that is slightly earlier than the time that ADC 107 will garner a data sample from the analog input signal 113. In this manner, the waveform of the analog input signal 113 is sampled in a parallel fashion so a plurality (N) of samples can be obtained and converted into digital data for subsequent processing.

Often, the analog bandwidth of the oscilloscope 101 is greater than the bandwidth inferred by the sample clock rate. In a quantitative illustration, suppose the analog bandwidth of the oscilloscope were 10 GHz. In order to utilize the full bandwidth of the oscilloscope, the Nyquist sampling rate of one sample every 50 psec is required. This is not practical using known ADCs. However, in accordance with the present teachings, by offsetting the clock signals of the ADCs 106-110 by 50 psec and sampling in parallel, this effective sampling rate is achieved. Moreover, the clocking requirements of the ADCs 106-110 to achieve this bandwidth are significantly less and well within the capabilities of known circuits. For example, if the clock of the ADCs 106-110 operates at 250 MHz, and there are N=80 ADCs operating in parallel, the desired 20 Giga samples per second (Gs/s) sample rate is achieved even though the fastest clock in the system has a frequency of only 250 MHz.

As can be appreciated, using the parallel ADCs 106-110 with slightly offset parallel sampling of the illustrative embodiments, the desired sampling bandwidth is achieved with a much lower clock speed. It should be noted that the analog bandwidth of a known sample and hold circuit (not shown) preceding each ADC is consistent with the desired overall system bandwidth.

Each respective analog data sample taken from the input analog signals 115 is converted to digital data sample words (typically 8 bits) 116-120 by the respective ADC 106-110. After conversion, the words 116-120 are provided to the logic block 111 and to the memory 112. In a specific embodiment, the memory 112 is a circular buffer implemented in hardware. The circular buffer receives each of the data samples 116-120 from each of the ADCs 106-110 and retains the data until the beginning of the next clock cycle, or until the capacity of the memory 112 is reached. At this point, barring the generation of a trigger from the logic block 111, the circular buffer begins writing over previously stored data and the buffering of the words 116-120 is repeated.

In parallel to the capturing of words at the memory 112, the words 116-120 are provided to the logic block 111. A host interface 123 provides threshold values, patterns and offsets to the logic block 111. The host interface 123 may be an input on the oscilloscope 101, or may be an input from another device such as a personal computer (PC).

In an embodiment, the logic block 111 is implemented in known firmware such as a field programmable gate array (FPGA). Alternatively, the logic block 111 may be implemented in a custom application specific integrated circuit (ASIC). In certain embodiments, the logic block 111 includes digital comparators in equal number to the number of ADCs. From the logic block 111, a vector of a plurality (N) of comparator outputs is generated for each clock cycle of the individual ADCs 106-110.

In other embodiments, there may be more comparators than ADCs. For example, certain triggering applications require the comparing of the present N samples to a history of previous samples. Illustratively, the user may want to generate a trigger if the input has been below a predetermined threshold for a required number of samples and then rises above another predetermined threshold. This can be achieved by buffering the incoming data words in memory 112 as required, and applying the stored values to additional comparators. Alternatively, rather than providing additional comparators, the results from the N comparators may be buffered for later comparison. In general, the memory 112 can provide sufficient buffering to allow triggering after a triggering event has occurred, so moderate trigger delay is not problematic.

From the outputs of the comparators, a memory trigger 121 may be generated, if the predetermined trigger condition is met. For example, if the goal were to detect a rising edge of the analog input signal 113 that exceeded a predetermined threshold, the appropriate threshold values for the N comparators would be set and at each new clock the vector output from the comparator bank would be tested for the desired pattern. Of course, the memory 112 may be triggered on falling edge triggers as well. Once the threshold is met, the memory trigger 121 triggers the memory 112 to output the data to the post processor via the bus 122. The post processor then provides a waveform based on the triggering event on the display 102.

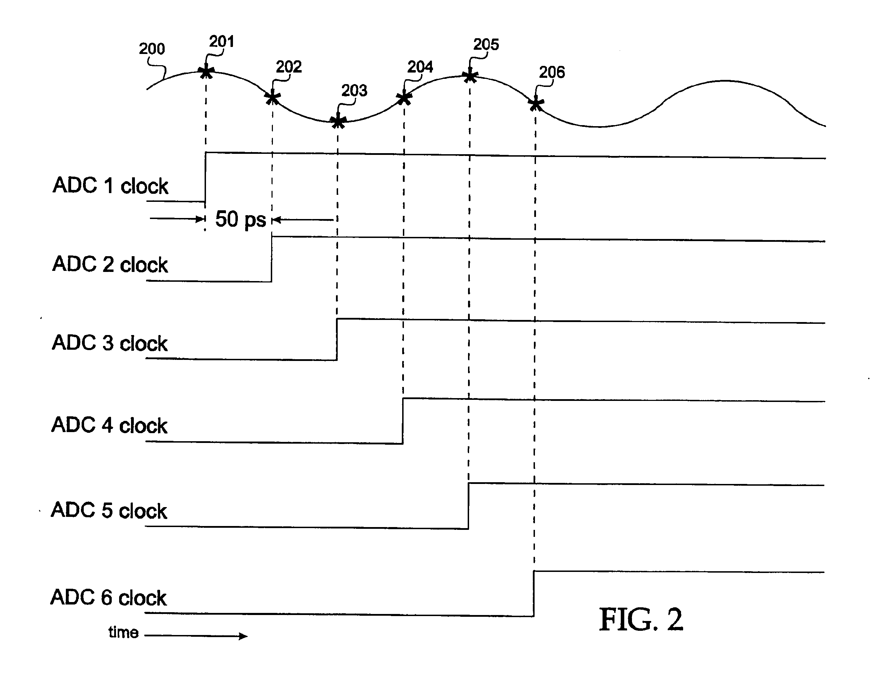

Fig. 2 is a timing diagram illustrating the sampling of an input analog signal 200 for N = 6 ADCs in accordance with an example embodiment. The use of six ADCs is merely illustrative and more or fewer ADCs may be used to sample the signal 200.

On the rise of the clock signal for the first ADC (ADC1), a first analog data sample 201 is taken. As noted previously, the clock of each successive ADC is delayed relative to the clock of the previous ADC(s), excepting of course the initial ADC. In keeping with the quantitative example described in connection with Fig. 1B, the clock of each successive ADC is delayed by 50 ps from the next previous ADC. As such, 50 ps after the rising edge of ADC1, the rising edge of the clock for ADC2 occurs and a second analog data sample 202 is taken. At 50 ps intervals, the rising edges of the clock signals of ADC3, ADC4, ADC5 and ADC6 trigger the taking of a third analog data sample 203, a fourth analog data sample 204, a fifth analog data sample 205 and a sixth analog data sample 206, respectively. As described above and in more detail herein, after conversion to digital samples (e.g., words 116-120) the data samples 201-206 are processed by respective comparators.

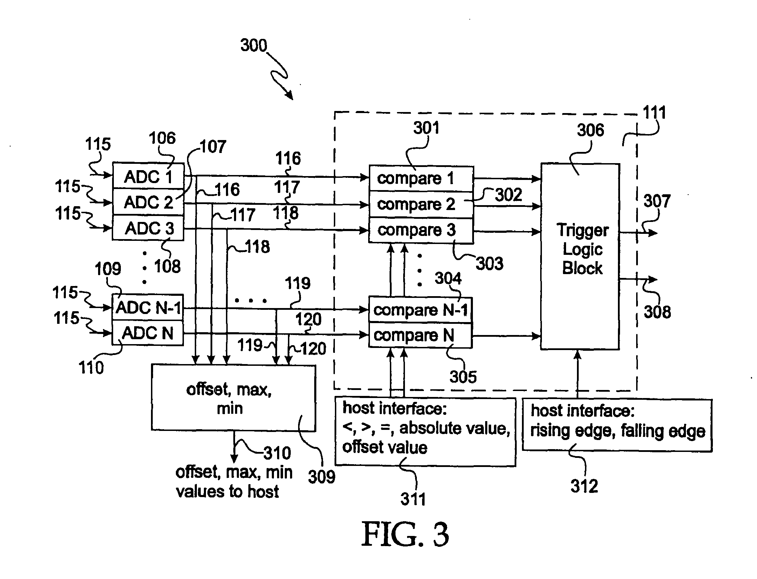

Fig. 3 is a simplified block diagram of a trigger architecture 300 in accordance with an example embodiment. The architecture 300 includes certain common features to the architecture 105 of the embodiments of Figs. 1 A and 1B and may be implemented as such. The details of these features are not repeated so as to avoid obscuring the presently described embodiment.

The analog input signals 115 are converted to digital data by the respective ADCs 106-110 in parallel as described previously. Each word 116-120 is provided to a respective digital comparator 301-305 as shown. Outputs from the digital comparators 301-305 are provided to a trigger logic block 306. The trigger logic block 306 provides a trigger detection flag 307, and optionally, a trigger location 308 to the memory (not shown in Fig. 3).

In accordance with an example embodiment, each of the digital comparators 301-305 is instantiated as gates in an FPGA or in a custom ASIC and includes a register that has been provided with one or more trigger threshold values. The function of the comparators 301-305 may be programmed on an application-specific basis. Accordingly, the trigger architecture 300 provides significant flexibility in measurement and testing.

The parallel structure of the ADCs 106-110, equal number of digital comparators 301-305, together with digital logic of the trigger logic block 306 forms a waveform digitizer with a comparatively flexible trigger mechanism. The waveform digitizer of the example embodiments allows the trigger architecture 300 to operate at the relatively low sampling rate of the individual ADCs 301-305. Since the trigger architecture 300 uses the sampled data stream from the ADCs, the full bandwidth of the input analog signal 113 is available for triggering. Thereby, trigger generation is performed digitally using parallel digital signal processing on the parallel data stream coming from the bank of moderate speed ADCs 301-305, which combine to form an effective high speed ADC.

In order to support a variety of triggering functions, the digital comparators 301-305 may be adapted to support multiple comparison operations. Illustratively, the comparison operations include, but are not limited to greater than (>) a threshold value, less than (<) a threshold value, equal to (=) a threshold value, and can operate on the actual value or the absolute value of the incoming digitized signal. In addition, an offset value may be subtracted from the data samples (words) in order to allow triggering on dynamic aspects of the waveform. The threshold values are provided to the registers of the digital comparators 301-305 via a host interface 311.

In parallel, the words 116-120 are provided to a threshold block 309. The threshold block 309 garners characteristics from the digital data from the waveform samples which can be used to alter the trigger comparator parameters or the waveform display parameters. The threshold block 309 functions can be performed by the host processor or by dedicated circuitry, depending on the required update rate. For purposes of illustration, the characteristics the threshold block 309 calculates may include the minimum value, the maximum value, and the average value over a defined time interval. These characteristics may then be used to generate a trigger for the waveform. For example, suppose a signal has a DC component of +5.0 V and an AC component of + 0.25 mV. It may be desirable to trigger on the time varying AC component of the signal. In this case, the DC component may be subtracted from each of the incoming signal values provided to the digital comparators 301-305 so the comparators only see the AC component of the composite signal.

In another illustration of the present teachings, it may be useful to trigger on one-half of the maximum data value over a recent time interval, or one-half of the average data words over a recent time interval. The threshold block 309 calculates these values based on the data over the desired time interval.

In yet another example of the present teachings, runt pulses identification is carried out via the trigger architecture 300. In serial data transmission, runt pulses can be problematic. As is known, a runt pulse has an amplitude that lies between a digital 1' and a digital '0.' In the present embodiment, the threshold block 309 supplies the running average (mean value) to the trigger architecture 300. This mean value is then subtracted from the incoming waveform samples upstream of the bank of comparators 301-305. If the comparators 301-305 are set to trigger if the absolute value of the signal is below an appropriate value, runt pulses can be detected. Illustratively, the digital comparators 301-305 are implemented via code in an FPGA or a custom ASIC to support absolute value comparisons for serial data streams. The number of consecutive data samples 116-120, which are below a set threshold could be the characteristic which generates the trigger for runt pulse identification.

After the data words 116-120 of the waveform are processed at the threshold block 309, the selected threshold value(s) 310 are provided to the host processor (not shown). The host processor may then input these values to the registers of the digital comparators 301-305 via the host interface 311 to automatically adjust the comparator thresholds for dependable triggering.

The trigger logic block 306 receives desired trigger characteristics from a host interface 312. These trigger characteristics include, but are not limited to rising edge triggers, falling edge triggers or specific patterns. For purposes of illustration, a specific pattern may be L (= integer) samples above a threshold followed by M (= integer) samples below the threshold. The trigger logic block, which is also implemented in firmware or a custom ASIC, receives the comparator output data from the digital comparators, and performs a discrimination function on the data. After one or more trigger thresholds are met, the trigger logic block 306 generates the trigger and provides the trigger detection 307 and trigger location 308 to the memory, which holds the digital waveform data. As will be appreciated by those skilled in the art, the trigger location provides the location of a triggering threshold value in the digital waveform data in the memory.

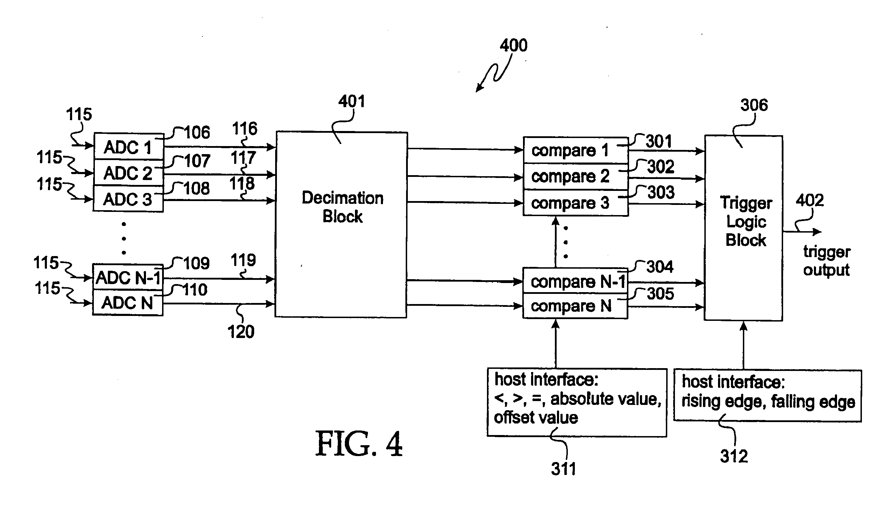

Fig. 4 is a simplified block diagram of a trigger architecture 400 in accordance with an example embodiment. The architecture 400 includes certain common features to the architectures 105, 300 of the embodiments of Figs. 1A, 1B and 3, respectively. The descriptions of these features are not repeated so as to avoid obscuring the presently described embodiment.

The architecture 400 includes a decimation block 401, implemented in firmware such as an FPGA or in dedicated circuitry such as a custom ASIC. The decimation block 401 is used to reduce the sampling rate of an incoming data stream and may be useful in certain applications. For example, often the ADC clock operates at a fixed rate. However, it may be useful to reduce the sample rate for applications requiring lower bandwidths. Notably, decimation can also be used to increase the dynamic range of the sampled signal.

The ADCs 106-110 provide N full rate data streams. The decimation block 401 can discard waveform sample data and output a lower rate data streams to the comparators 301-305. If decimation is achieved by discarding samples, no improvement in dynamic range will result. If, however, decimation is performed by filtering the input data stream and then sampling the filtered data stream at a lower rate, dynamic range can be improved. These data are then compared to threshold values as described previously and provided to the trigger logic block 306. The degree of decimation may be varied depending on application. For example, it may be desired to reduce the sample rate to by a factor of two. In this case every other sample data word is discarded but the dynamic range is not enhanced.

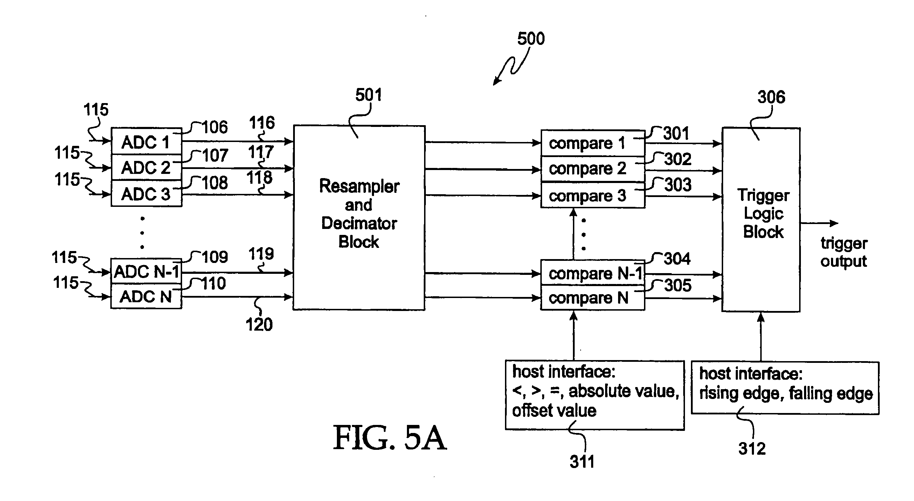

Fig. 5A is a simplified block diagram of a trigger architecture 500 in accordance with an example embodiment. The architecture 500 includes certain common features to the architectures 105, 300 and 400 of the embodiments of Figs. 1A, 1B, 3 and 4, respectively. The descriptions of these features are not repeated so as to avoid obscuring the presently described embodiment.

The architecture 500 includes a resampler and decimator block 501 implemented in firmware or a custom ASIC. The decimator function of the block 501 is useful in discarding words to reduce the sample rate as desired. The resampler function of the block 501 is useful for changing the clock rate of the incoming data stream from the ADCs to be synchronous to an arbitrary clock. The resampling may provide upsampling in which data are interpolated by known methods to a higher sample rate; or downsampling in which data are decimated to a lower sample rate.

In operation, the data from the ADCs 106-110 are provided to the block 501. The data are decimated by the decimator function of the block. The data are resampled and provided as N lower rate data streams. Some applications may perform the decimation first; others may prove more efficient if the decimation is performed last. The lower rate data streams, which are now substantially synchronous to the clock associated with the original generation of the data stream, are input to respective comparators 301-305, where threshold comparisons are made as described previously. For serial data link applications the resampled data can then be observed by the comparators to produce the desired serial data bit stream. Patterns in this data stream can be searched for via the trigger logic block 306 (for example, to produce a trigger when a comma character is observed). As before, threshold data are provided to the trigger logic block 306 and can be used to adjust the comparator thresholds based on the amplitude and DC offset of the incoming data stream.

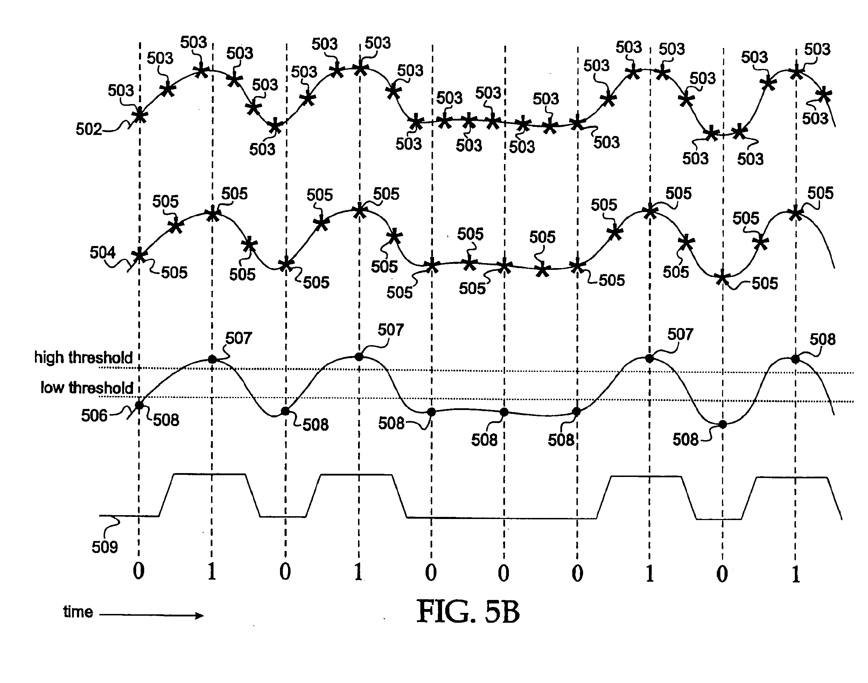

Fig. 5B is a timing diagram illustrating resampling of a sample waveform using the architecture 500. In this example a first waveform 502 is a representative analog waveform from a serial data link (not shown). The waveform 502 includes a plurality of data samples 503 garnered at the sample times of the high speed ADC comprised of the plurality of ADCs described previously in connection with example embodiments.

A second waveform 504 is a resampled version of the first waveform 502. The sample rate has been changed to be synchronous with the original clock that generated the serial data stream using an arbitrary resampler. The samples 505 show the reduced sample rate compared to the sample rate of waveform 502.

A third waveform 506 is a down-sampled version of the second waveform. In this illustration, every other sample has been discarded. The remaining samples are timed to be at the best location along the waveform to extract the digital content.
Representative high and low threshold values for the comparators are shown. Data samples 507 above the high threshold will be mapped into a logical 1, and data samples 508 below the low threshold will be mapped into a logical 0.

A fourth waveform 509 is the digital output of the comparators. The data values are listed below the waveform. This pattern of ones and zeros can be searched for patterns which can be used to generate a trigger.

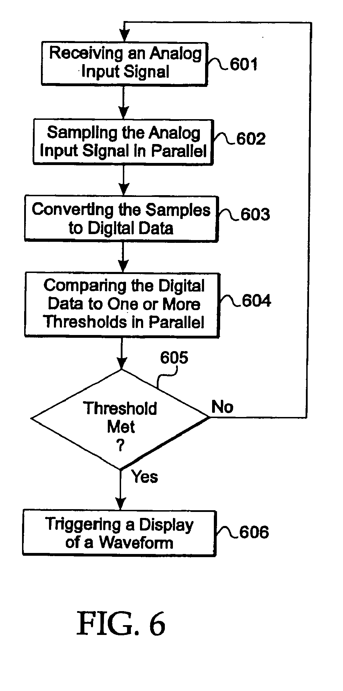

Fig. 6 is a flow-chart of method of processing measurement data in a measurement system in accordance with an example embodiment. The method may be implemented in and via the measurement system and trigger architectures described in connection with embodiments above.

The method begins at step 601 with the receiving of an analog input signal, such as signal 113. At step 602, time-staggered sampling of the analog input signal is carried out in parallel. For example, the sampling of step 602 includes sampling the signals 115 at each of the ADCs 106-110 in parallel and with temporal offset. As described previously, the temporal offset between sampling at each ADC provides a relatively high sampling rate (or high sample bandwidth) even though the clock rate of the individual ADCs is comparatively low.

At step 603, the method continues with the converting of the analog data samples into digital data samples at the ADCs. After being converted to digital samples, at step 604 the data are compared to one or more trigger thresholds in parallel via the bank of comparators (e.g., comparators 301-305). If, at step 605, a threshold is met, a trigger(s) is generated to provide a waveform on the display of the oscilloscope. If, on the other hand, a trigger threshold is not met in the instant clock cycle, the method repeats at step 601. Moreover, after the trigger is generated, the method repeats at step 601.

Notably, the present method may also include decimation and resampling. The threshold values and any calculations may be carried out in the method per the described example embodiments.

Beneficially, the parallel structure of the waveform digitizer of the example embodiments allows the trigger architecture to operate at the sampling rate of the individual ADCs. Since the trigger architectures of the embodiments use the sampled data stream from the ADCs, full bandwidth of the input analog signal is available for triggering. Trigger generation is performed digitally using parallel digital signal processing on the parallel data stream coming from the bank of moderate speed ADCs, which together form a high speed ADC. The trigger architectures, measurement devices and methods of the example embodiments provide the same fidelity and signal bandwidth as the high speed ADC. By applying a collection of relatively simple digital operations on each of the output data streams from the parallel ADC, many of the common triggering functions can be realized with only a modest amount of supporting digital logic.

In accordance with example embodiments, a trigger architecture, a measurement system and a method of garnering waveform data for display and processing are described. One of ordinary skill in the art appreciates that many variations that are in accordance with the present teachings are possible and remain within the scope of the appended claims. These and other variations would become clear to one of ordinary skill in the art after inspection of the specification, drawings and claims herein. The invention therefore is not to be restricted except within the spirit and scope of the appended claims.

The disclosures in United States patent application No. 11/363,939, from which this application claims priority, and in the abstract accompanying this application are incorporated herein by reference.

## Claims

1. A trigger architecture (105), comprising:
a plurality of parallel analog-to-digital converters (ADCs) (106,107,108,109,110) operative to garner data samples (116,117,118,119,120) in parallel from an input signal (113) at different times in a clock signal period; and
a logic block (111) comprising a plurality of digital comparators (301,302,303,304,305), which are adapted to compare each of the data samples to one or more threshold values in parallel.

2. The trigger architecture (105) of claim 1, wherein each of the plurality of ADCs (106,107,108,109,110) includes a sequence ofN (N=integer) ADCs and, excepting a first ADC (106), each ADC has a respective clocking signal that is delayed compared to the respective clocking signals of previous ADCs of the sequence of ADCs.

3. The trigger architecture (105) of claim 1, further comprising a threshold block (309) connected to each of the plurality of ADCs (106,107,108,109,110) and operative to receive each of the data samples in parallel.

4. The trigger architecture (105) of claim 1, further comprising a resampler (501) and decimator block (401) operative to receive the data samples from the plurality of ADCs (106,107,108,109,110) and to provide the data samples (116,117,118,119,120) to the plurality of digital comparators of the logic block.

5. A measurement system (100), comprising:
a trigger architecture (105) having:
a plurality of parallel analog-to-digital converters (ADCs) (106,107,108,109,110) operative to garner data samples (116,117,118,119,120) in parallel from an input signal (113) at different times in a clock signal period; and
a logic block (111) comprising a plurality of digital comparators (301,302,303,304,305), which are adapted to compare each of the data samples to one or more threshold values in parallel.

6. The measurement system (100) of claim 5, further comprising an oscilloscope (101).

7. The measurement system (100) of claim 5, wherein each of the plurality of ADCs (106,107,108,109,110) includes a sequence of N (N=integer) ADCs and, excepting a first ADC (106), each ADC has a respective clocking signal that is delayed compared to the respective clocking signals of previous ADCs of the sequence of ADCs.

8. In a measurement system (100), a method of processing measurement data, the method comprising:
receiving an analog input signal (601);
sampling the analog input signal in parallel (602), wherein the sampling is sequential in time;
converting the samples to digital data (603);
comparing the data to one or more thresholds in parallel (604); and
if a threshold is met, generating a trigger to a display of a waveform based on the digital data (606).

9. The method of claim 8, further comprising, before the comparing, decimating the digital data.

10. The method of claim 8, further comprising identifying a runt pulse by comparing one of the data to an average value.
